**Europäisches Patentamt**

**European Patent Office**

**Office européen des brevets**

(19)

(11) Numéro de publication : **0 297 948 B1**

(12)

# FASCICULE DE BREVET EUROPEEN

(45) Date de publication du fascicule du brevet :
**23.10.91 Bulletin 91/43**

(51) Int. Cl.$^5$ : **G01V 1/20, G01L 9/08, G01L 23/10, H01L 41/08, H04R 17/00**

(21) Numéro de dépôt : **88401549.6**

(22) Date de dépôt : **21.06.88**

(54) Transducteur piézo-électrique comportant plusieurs éléments sensibles coaxiaux.

(30) Priorité : **30.06.87 FR 8709262**

(43) Date de publication de la demande :
**04.01.89 Bulletin 89/01**

(45) Mention de la délivrance du brevet :
**23.10.91 Bulletin 91/43**

(84) Etats contractants désignés :
**DE GB IT NL**

(56) Documents cités :
**EP-A- 0 174 897**

(56) Documents cités :
**FR-A- 2 145 099**
**FR-A- 2 556 165**
**PATENT ABSTRACTS OF JAPAN, vol. 10, no. 20 (E-376)[2077], 25 janvier 1986, page 52 E 376; & JP-A-60 180 181 (NIPPON TOKUSHU TOGYO K.K.) 13-09-1985**

(73) Titulaire : **INSTITUT FRANCAIS DU PETROLE**
**4, Avenue de Bois-Préau**
**F-92502 Rueil-Malmaison (FR)**

(72) Inventeur : **Beauducel, Claude**
**8, rue Talon**
**F-60119 Hénonville (FR)**

## Description

La présente invention concerne un transducteur piézo-électrique comportant une combinaison d'éléments sensibles coaxiaux.

Un tel transducteur piézo-électrique peut être utilisé par exemple pour la mesure de pressions, notamment dans les domaines de l'océanographie ou de la prospection sismique, ou bien encore pour la mesure de contraintes directionnelles.

Les transducteurs piézo-électriques comportent généralement un ou plusieurs éléments sensibles constitués chacun d'un substrat possédant des propriétés piézo-électriques et deux électrodes ou armatures disposées de part et d'autre.

Le substrat peut être réalisé sous la forme de disques en céramique de dimensions relativement petites, inclus dans un boîtier rigide pourvu d'une ou plusieurs faces transparentes aux ondes acoustiques. Le brevet français n° 2.122.675 montre la réalisation d'un capteur piézo-électrique où un, et de préférence deux disques en céramique, muni chacun de ses électrodes, sont fixés sur deux plaques souples en regard l'une de l'autre. Une au moins des plaques est pourvue d'une partie périphérique rigide plus épaisse venant en appui contre l'autre. Les disques peuvent être réalisés par frittage de matériaux en poudre possédant des propriétés piézo-électriques. Ils possèdent une grande sensibilité mais sont fragiles mécaniquement.

Le substrat peut aussi être réalisé sous la forme de rubans ou de plaques souples réalisés à partir d'un matériau synthétique plastique auquel un traitement confère des propriétés piézo-électriques. On utilise généralement des matériaux tels que le PVDF (polyfluorure de vinylidène), le polyéthylène, le PTFE (polytétrafluorure d'éthylène) etc, que l'on étire avant de leur appliquer une polarisation électrique.

Comme les spécialistes le savent, on peut utiliser aussi des copolymères qui ont la propriété de cristalliser directement sous une forme polarisable sans qu'il soit nécessaire de les étirer au préalable.

Par l'emploi de bandes ou plaques souples, on peut construire des hydrophones continus de longueur relativement grande qui réalisent des filtrages en nombre d'onde. Incorporés dans des flûtes sismiques remorquées par un navire, ils permettent notamment de filtrer certains bruits parasites et de faciliter la réception des signaux renvoyés par des discontinuités du sous-sol immergé, en réponse à des ondes sismiques émises par une sourve remorquée.

On a déjà réalisé des transducteurs piézo-électriques ayant une forme coaxiale en utilisant les techniques connues dans le domaine de la fabrication des câbles de transmission de signaux. Le matériau diélectrique disposé entre l'armature interne et l'armature externe est alors remplacé par un substrat réalisé à partir d'un matériau synthétique plastique tel que ceux rappelés ci-dessus et polarisé radialement. L'armature externe est suffisamment fine pour être transparente aux ondes acoustiques. On emploie par exemple un film de peinture conductrice ou une métallisation sous-vide. Une gaine d'étanchéité en élastomère isole électriquement l'armature externe. Celle-ci et l'armature interne sont connectées à un préamplificateur adaptateur d'impédance. Comme on utilise des techniques de fabrication classiques, le prix des transducteurs coaxiaux est souvent plus avantageux que celui des transducteurs à films plats et minces. En outre l'armature extérieure constitue un blindage électrique naturel.

De tels transducteurs piézo-électriques coaxiaux sont décrits par exemple dans le brevet US-4.568.851, la demande de brevet PCT publiée WO 86/00.757 ou EP-A-174897.

Les câbles coaxiaux piézo-électriques sont souvent impropres à une utilisation dans l'eau lorsqu'ils sont soumis à des perturbations diverses. C'est le cas lorsqu'ils sont employés comme hydrophones et remorqués en mer pour les besoins de la prospection sismique ou pour effectuer des repérages et localisations de sources sonores. Une accélération radiale provoque une surpression d'un côté du câble et une dépression du côté opposé. Des charges électriques sont engendrées du fait des variations de pression. Elles sont de signes contraires de part et d'autre du câble mais en général, il n'y a pas de compensation totale. Une accélération crée donc une tension parasite. Si un tel câble piézo-électrique subit un fléchissement au cours de son remorquage, il va se produire une compression du substrat sensible du côté convexe et une extension du côté opposé. Les charges de signes opposés qui apparaissent, ne se compensent généralement pas non plus. Comme la sensibilité radiale, les signaux parasites nés des accélérations ou flexions peuvent même masquer les signaux utiles à mesurer.

Le transducteur piézo-électrique selon la revendication 1 permet d'éviter les inconvénients ci-dessus mentionnés.

Un nombre pair d'éléments sensibles dont les polarisations radiales sont opposées deux à deux, peuvent être répartis en couronne et noyés dans un matériau d'enrobage. Ils peuvent encore être disposés à l'intérieur d'une gaine pourvue d'un évidement central servant par exemple à faire passer des câbles divers ou des canalisations éventuellement.

L'emploi d'éléments sensibles de dimensions sensiblement identiques qui engendrent de ce fait des tensions analogues en réponse à une même contrainte et l'interconnexion électrique de leurs armatures, permettent ainsi de compenser à volonté les accélérations ou flexions qui peuvent leur être appliquées suivant des directions éventuellement très différentes.

En multipliant ainsi le nombre d'éléments sensibles, on peut obtenir un transducteur piézo-électrique capable de compenser efficacement les accélérations ou flexions radiales quelles que soient leurs directions d'application. Mais on peut, aussi au contraire, en privilégiant une direction particulière, obtenir un transducteur piézo-électrique capable de mesurer des contraintes directionnelles.

D'autres caractéristiques et avantages du transducteur selon l'invention apparaîtront à la lecture de la description de modes de réalisations donnés à titre d'exemples non limitatifs, en se référant aux dessins annexés où :

— la figure 1 montre un transducteur piézo-électrique pourvu de deux éléments sensibles coaxiaux, disposés côte à côte ;

— la figure 2 montre une portion d'éléments sensibles piézo-électriques.

— la figure 3 montre, vu en coupe, un transducteur pourvu de quatre éléments sensibles interconnectés électriquement deux à deux ; et

— la figure 4 montre, également en coupe, un transducteur pourvu d'une pluralité d'éléments sensibles répartis dans une gaine où est ménagé un évidement tubulaire pour des câbles ou des canalisations.

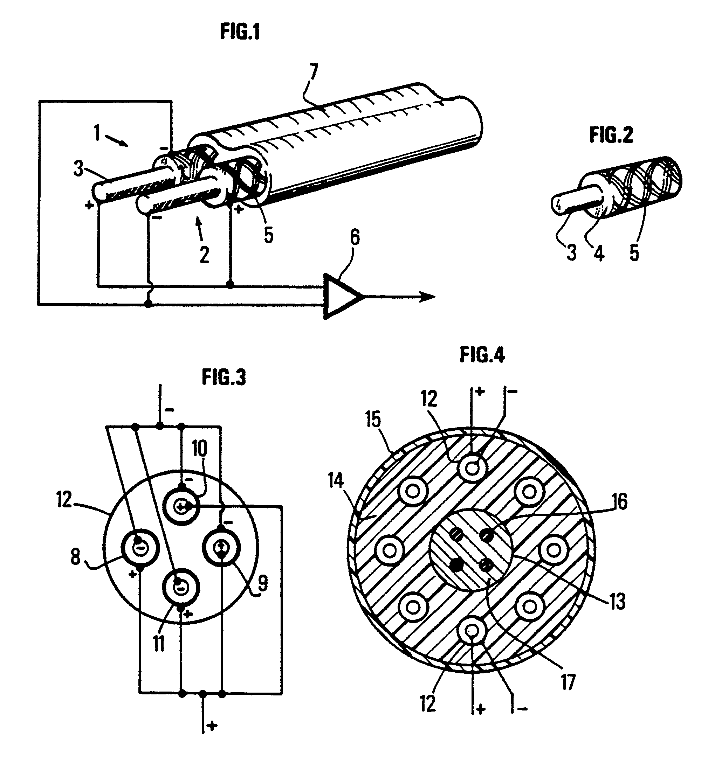

Suivant le mode de réalisation de la figure 1, le dispositif comporte deux éléments sensibles coaxiaux 1, 2. Chacun d'eux comporte (figure 2) une électrode ou armature intérieure 3 constituée par exemple d'un fil métallique noyé dans une substance souple possédant des propriétés piézo-électriques, moulée sous forme cylindrique. Contre la surface extérieure du cylindre est appliquée une armature extérieure 5.

La substance utilisée peut être constituée d'une poudre possédant des propriétés piézo-électriques (du PZT par exemple) mélangée à un matériau de liaison souple. On peut utiliser aussi un polymère du type PVDF notamment. Le procédé de fabrication inclut un étirage de la substance noyant l'armature interne de manière à orienter ses molécules avant l'application du champ électrique qui lui donne sa polarisation. La substance 4 peut être réalisée aussi à partir de copolymères d'un type connu choisis pour cristalliser directement sous une forme polarisable. L'armature externe 5 est réalisée par exemple sous la forme d'une tresse de fils conducteurs. De préférence, cette tresse est enrobée dans une couche d'un matériau composite conducteur. Elle peut être réalisée aussi plus simplement sous la forme d'une couche mince de ce même matériau composite ou encore d'un film métallique déposé sous vide par exemple. Ces techniques de fabrication sont bien connues des spécialistes et permettent de fabriquer de façon continue des très grandes longueurs de câble piézo-électrique.

Les deux éléments sensibles coaxiaux 1, 2 sont des sections de câble de même longueur mais prélevées dans des câbles coaxiaux ayant des polarisations radiales opposées. De cette manière, une même contrainte appliquée aux deux éléments sensibles engendrant des charges électriques de signes opposés sur les armatures identiques. On interconnecte alors les armatures portant dans ce même exemple des charges de même signe. L'armature externe de l'une est ainsi connectée électriquement à l'armature interne de l'autre et réciproquement. Chaque paire d'armatures interconnectées est réunie à une même borne d'un préamplificateur adaptateur 6. Les deux éléments sensibles 1, 2 sont disposés côte-à-côte et réunis ensemble par une gaine isolante en élastomère 7 transparente aux ondes acoustiques.

Avec ce mode d'interconnexion, il se produit une addition des charges électriques développées sur les armatures des deux éléments sensibles par l'application de pressions qui sont des grandeurs isotropes. On vérifie expérimentalement aussi que l'ensemble ainsi constitué présente une meilleure immunité aux bruits dus aux accélérations et aux flexions en raison des compensations de charges qui se produisent. C'est vrai en particulier quand une même contrainte directionnelle provoque une compression de l'un des éléments sensibles et un étirement de l'autre.

Ceci se produit notamment dans le mode de réalisation de la figure 1 où les contraintes appliquées ont une composante dans le plan passant par les axes des deux éléments sensibles. Les effets de pressions s'ajoutant et les contraintes parasites se compensant, le rapport du signal au bruit augmente.

On peut améliorer encore cette immunité, si on réunit dans une même gaine plusieurs paires d'éléments sensibles à polarisations radiales inverses interconnectées de la façon indiquée plus haut. Suivant le mode de réalisation de la figure 3, quatre éléments sensibles 8, 9, 10, 11 formant deux paires sont réunies dans une même gaine 12. Ces deux paires (8, 9) et (10, 11) sont disposées respectivement dans des plans différents qui peuvent être perpendiculaires par exemple. De la même façon, on interconnecte les armatures où des charges de signes opposés apparaissent pour une même accélération ou une même flexion. Ainsi les armatures externes des éléments sensibles 8, 11 sont interconnectées par exemple avec les armatures internes des éléments 9 et 10, et les armatures internes des mêmes éléments 8, 11 sont, elles, interconnectées aux armatures externes des éléments 9 et 10. Les deux interconnexions réalisées sont connectées respectivement aux bornes d'un préamplificateur adaptateur (non représenté) comme dans le cas précédent. On obtient là encore une augmentation du signal au bruit.

Le nombre d'éléments sensibles peut être multiplié pour rendre encore moins directionnelle la compensation des accélérations et des flexions subies par le transducteur et améliorer son immunité aux bruits.

Suivant le mode de réalisation de la figure 4, on dispose un certain nombre de paires d'éléments sensibles de polarisations radiales opposées (quatre par exemple) autour d'un tube central creux 13 et on les maintient en position les unes par rapport aux autres par un matériau d'enrobage isolant 14.

L'ensemble est protégé extérieurement par une gaine en élastomère 15. On réalise les interconnexions électriques définies précédemment de manière que les charges électriques apparaissant sur les différentes armatures en raison des accélérations et flexions se compensent. Dans le tube creux central 13, on peut faire passer des éléments allongés 16 tels que des câbles de traction, des câbles d'alimentation électrique, des câbles de transmission de signaux, etc. Les différents éléments passant par le tube central sont maintenus en place par une injection dans celui-ci d'un gel 17 aux silicones par exemple.

On peut réaliser ainsi une flûte sismique de grande longueur.

On ne sortirait pas du cadre de l'invention en donnant aux différents éléments sensibles une configuration telle que le transducteur soit rendu sélectif à des contraintes reçues suivant une ou plusieurs directions différentes de manière à réaliser par exemple des jauges de contrainte. Au lieu de la disposition en couronne montrée aux figures 3, 4, on peut choisir une autre répartition où les éléments sensibles sont disposés dans un même plan ou bien à des distances différentes du centre.

## Revendications

1. Transducteur piézoélectrique comportant des éléments sensibles piézoélectriques (1, 2) constitués chacun d'un substrat tubulaire (4) polarisé radialement, d'une électrode intérieure (3) et d'une électrode extérieure (5), les substrats tubulaires étant polarisés suivant une première direction ou une deuxième direction opposée à la première et les éléments sensibles avec des substrats polarisés suivant la première et la deuxième direction étant associés par paires avec leurs électrodes interconnectées électriquement deux à deux, caractérisé en ce qu'il comporte au moins une paire d'éléments sensibles (1, 2) de dimensions identiques disposés côte à côte et une gaîne d'enrobage (7) pour lier étroitement ensemble les deux éléments sensibles de ladite paire, de façon que leur réponse à des flexions ou accélérations soient sensiblement identiques.

2. Transducteur selon la revendication 1, caractérisé en ce qu'il comporte un nombre pair d'éléments sensibles (8 à 11) réalisés à partir de substrats dont les polarisations radiales sont opposées deux à deux, ces éléments sensibles étant répartis en couronne et noyés dans un matériau d'enrobage.

3. Transducteur selon la revendication 1, caractérisé en ce qu'il comporte un nombre pair d'éléments sensibles réalisés à partir de substrats dont les polarisations radiales sont opposées deux à deux, ces éléments sensibles étant disposés à l'intérieur d'une gaine (15) et noyés dans un matériau d'enrobage (14), ladite gaine étant pourvue d'un évidement central (13).

4. Transducteur selon la revendication 3, caractérisé en ce que l'évidement central (13) est tubulaire et des éléments allongés (16) sont logés dans ledit évidement.

5. Transducteur selon la revendication 4, caractérisé en ce que ledit évidement contient une substance diélectrique (17).

6. Transducteur selon la revendication 3, caractérisé en ce que ta gaine (15) est réalisée en un matériau amortissant les bruits d'écoulement.

7. Transducteur selon l'une des revendications 2 à 6, caractérisé en ce que les armatures des différents éléments sensibles sont interconnectées de manière à compenser mutuellement les charges électriques apparaissant sur les différentes armatures, consécutivement à des accélérations ou des flexions suivant au moins un plan radial.

8. Transducteur selon la revendication 2, caractérisé en ce que les éléments sensibles sont répartis à l'intérieur d'une gaine pourvue d'un évidement central (13).

9. Transducteur selon la revendication 4 ou 5, caractérisé en ce que lesdits éléments allongés (16) sont des câbles ou des canalisations.

10. Transducteur selon la revendication 3, caractérisé en ce que la disposition relative des éléments sensibles est choisie pour favoriser au moins une direction de plus grande sensibilité aux contraintes appliquées.

## Claims

1. A piezoelectric transducer comprising piezoelectric sensitive elements (1, 2) each made of a radially polarised tubular substrate (4), an internal electrode (3) and an external electrode (5), the tubular substrates being polarised along a first direction or a second direction opposite to the first and the sensitive elements with the polarised substrates following the first and the second directions being associated by pairs with their electrodes electrically inter-connected two to two, characterised in that the device comprises at least one pair of sensitive elements (1, 2) of identical size arranged side by side and enclosed in a casing (7) to link closely together the two sensitive elements of the said pair in such a way that their response to flexions or accelerations is largely identical.

2. A transducer according to claim 1, characterised in that it comprises an even number of sensitive elements (8 to 11) made from substrates in which the radial polarisations of two are opposite to those of another two, the sensitive elements being arranged in a circuit and enclosed in a casing material.

3. A transducer according to claim 1, characterised in that it comprises an even number of sensitive elements made of substrates in which the radial polarisations of two are opposite to those of another two, arranged in a housing (15) and enclosed in a casing material (14), the said casing being fitted with a central outlet (13).

4. A transducer according to Claim 3, characterised in that the central outlet (13) is tubular and the extended elements (16) are housed in said outlet.

5. A transducer according to Claim 4, characterised in that the outlet contains a dielectric substance (17).

6. A transducer according to Claim 3, characterised in that the casing (15) is made of a noise absorbent material.

7. A transducer according to any one of claims 2 to 6, characterised in that the plates of the various sensitive elements are inter-connected in such a way as to mutually compensate the electric charges appearing on the various plates.

8. A transducer according to Claim 2, characterised in that the sensitive elements are distributed inside a housing fitted with a central outlet (13).

9. A transducer according to Claim 4 or 6, characterised in that the said extended elements (16) are cables or channels.

10. A transducer according to Claim 3, characterised in that the relative arrangement of the sensitive elements is selected to emphasise at least one direction of greater sensitivity to the stresses applied.

## Patentansprüche

1. Piëzoelektrischer Wandler mit piëzoelektrischen empfindlichen Elementen (1, 2), die je durch ein röhrenförmiges radial polarisiertes Substrat (4), eine Innenelektrode (3) und eine Außenelektrode (5) gebildet sind, wobei die röhrenförmigen Substrate entsprechend einer ersten Richtung oder einer zweiten Richtung entgegengesetzt zur ersten polarisiert sind und die empfindlichen Elemente mit polarisierten Substraten entsprechend der ersten Richtung und der zweiten Richtung paarweise mit ihren elektrisch zu je zwei zusammengeschalteten Elektroden einander zugeordnet sind, dadurch gekennzeichnet, daß er wenigstens ein Paar empfindlicher Elemente (1, 2) identischer Abmessungen, die seitlich nebeneinander angeordnet sind und eine umgreifende Hülle (7) umfaßt, um eng die beiden empfindlichen Elemente dieses Paares zusammenzufassen, derart, daß deren Ansprechverhalten auf Durchbiegungen oder Beschleunigungen im wesentlichen gleich werden.

2. Wandler nach Anspruch 1, dadurch gekennzeichnet, daß er eine gerade Zahl empfindlicher Elemente (8 bis 11) umfaßt, die aus Substraten hergestellt sind, deren radiale Polarisationen zu jeweils zwei einander entgegengesetzt sind, wobei diese empfindlichen Elemente kranzartig verteilt und in ein Hüllmaterial eingebettet sind.

3. Wandler nach Anspruch 1, dadurch gekennzeichnet, daß er eine gerade Anzahl empfindlicher Elemente umfaßt, die aus Substraten hergestellt sind, deren radiale Polarisationen zu je zwei einander entgegengesetzt sind, wobei diese empfindlichen Elemente im Inneren einer Hülle (15) angeordnet und in einem Hüllmaterial (14) eingebettet sind, wobei die Hülle mit einer zentralen Ausnehmung (13) versehen ist.

4. Wandler nach Anspruch 3, dadurch gekennzeichnet, daß die mittige Ausnehmung (13) röhrenförmig ist und längliche Elemente (16) in dieser Ausnehmung gelagert sind.

5. Wandler nach Anspruch 4, dadurch gekennzeichnet, daß diese Ausnehmung eine dielektrische Substanz (17) enthält.

6. Wandler nach Anspruch 3, dadurch gekennzeichnet, daß die Hülle (15) aus einem die Strömungsgeräusche dämpfenden Material hergestellt ist.

7. Wandler nach einem der Ansprüche 2 bis 6, dadurch gekennzeichnet, daß die Bewehrungen der verschiedenen empfindlichen Elemente derart miteinander verbunden sind, daß gegenseitig die elektrischen an den verschiedenen Bewehrungen auftretenden Ladungen anschließend als Folge von Beschleunigungen oder Durchbiegungen entsprechend wenigstens einer radialen Ebene kompensiert werden.

8. Wandler nach Anspruch 2, dadurch gekennzeichnet, daß die empfindlichen Elemente im Inneren einer mit einer mittigen Ausnehmung (13) versehenen Hülle verteilt sind.

9. Wandler nach Anspruch 4 oder 5, dadurch gekennzeichnet, daß die länglichen Elemente (16) Kabel oder Leitungen sind.

10. Wandler nach Anspruch 3, dadurch gekennzeichnet, daß die Relativanordnung der empfindlichen Elemente gewählt ist, um wenigstens eine Richtung grösserer Empfindlichkeit für angelegte Beanspruchungen zu begünstigen.

## FIG.1

**7**

**1**

**3**

**+**

**2**

**5**

**6**

## FIG.2

**3  4  5**

## FIG.3

**10**

**12**

**8**

**11**

**9**

## FIG.4

**12  +  −**

**15**

**14**

**16**

**13**

**17**

**12  +  −**